# EUROPÄISCHE PATENTSCHRIFT

(11) **EP 0 400 387 B1**
(45) Veröffentlichungstag und Bekanntmachung des Hinweises auf die Patenterteilung: **21.02.1996**
(21) Anmeldenummer: 90109039.9
(22) Anmeldetag: 14.05.1990
(51) Int. Cl.: G01R 31/308, H01L 21/306

(54) **Verfahren zum grossflächigen elektrischen Kontaktieren eines Halbleiterkristallkörpers mit Hilfe von Elektrolyten**
Process to make a large-area electrolytical contact on a semiconductor body
Procédé pour former un contact électrolytique de grande surface sur un corps semi-conducteur

(30) Priorität: 31.05.1989 DE 3917723
(43) Veröffentlichungstag der Anmeldung: 05.12.1990
(73) Patentinhaber: SIEMENS AKTIENGESELLSCHAFT, D-80333 München (DE)
(72) Erfinder: Föll, Helmut, Dr., D-8000 München 80 (DE); Lehmann, Volker, Dr., D-8000 München 80 (DE)

(56) Entgegenhaltungen:
- EP-A- 0 296 348
- US-A- 4 628 591
- JOURNAL OF THE ELECTROCHEMICAL SOCIETY Bd. 135, Nr. 11, November 1988, MANCHESTER, NH US Seiten 2831 - 2835 V.LEHMANN ET AL. 'Minority Carrier Diffusion Length Mapping in Silicon Wafers Using a Si-Electrolyte-Contact'

## Beschreibung

Die Erfindung betrifft ein Verfahren zum großflächigen elektrischen Kontaktieren von Halbleitern nach dem Oberbegriff des Patentanspruchs 1, mit welchem gute elektrische Kontakte mit hoher Strombelastbarkeit erzeugt werden können. Die Herstellung solcher Kontakte zu Halbleiteroberflächen ist aus vielen Gründen von technischem Interesse. Ein Beispiel sind elektrochemische Prozesse, bei welchen Teile der Oberfläche des Halbleiters einem Elektrolyten ausgesetzt werden. Einige Anwendungen am Beispiel von Silicium sind: Elektropolieren, Defektätzen, Erzeugung sogenannter poröser Siliciumschichten, galvanische Abscheidung, meßtecnnische Zwecke.

Bei den genannten Verfahren wurde bisher die Rückseite oder, allgemeiner, Teile der nicht dem Elektrolyten ausgesetzten Oberfläche mit einem ohmschen Kontakt zur Zuleitung des benötigten Stroms versehen. Die Erzeugung guter elektrischer Kontakte auf Halbleitern ist jedoch im allgemeinen ein schwieriger und nicht zerstörungsfreier Prozeß, der in der Regel eine Vorbehandlung des Halbleiters und das Aufbringen einer oder mehrerer Metallschichten erfordert. Auch durch Einreiben von Indium-Gallium-Eutektikum in die zu kontaktierende Rückseite wie in dem Artikel von Lehmann et al in Jet Propulsion Laboratory, California Institute of Technology, JPL-Publication 84/23, 1983, S.527ff beschrieben, lassen sich relativ gute Kontakte herstellen. Das Verfahren ist jedoch für großflächige Kontakte und für großtechnische Anwendungen nicht geeignet.

Die Herstellung von weniger guten (nicht ohmschen) Kontakten durch das Aufpressen von Metallplatten oder -spitzen ist zwar einfacher, genügt aber häufig nicht den Ansprüchen, die an Kontaktwiderstand und Homogenität des Stromflusses durch die Scheibe gestellt werden.

In der US-Patentschrift 4 628 591 von Zorinsky et al, nach der der Oberbegriff des Anspruchs 1 gebildet ist, ist eine Stromzufünrung über einen Elektrolytkontakt beschrieben. Dabei wird die Rückseite ebenfalls mit einem Elektrolyt in Kontakt gebracht. In diesem befindet sich eine Elektrode, die über eine Gleichspannungsquelle mit der Elektrode im Elektrolyt an der Vorderseite der Halbleiterscheibe (Arbeitsseite) verbunden ist. Der benötige Stromfluß durch den Elektrolyten an der Vorderseite bedingt eine Polung der Gleichspannungsquelle derart, daß durch den vorderseitigen Elektrolyten nur bei sehr hohen Spannungen ein Strom fließen kann, da die vorderseitige Elektrolytzelle eine in Sperrichtung gepolte Diode darstellt. Die Höhe der notwendigen Spannung ist abhängig vom spezifischen Widerstand ρ des Halbleiterkristalls, so daß das Verfahren nur für Halbleiter mit ρ≲0,1Ωcm eingesetzt werden kann.

Aufgabe der Erfindung ist es daher, eine einfache, zerstörungsfreie elektrische Kontaktierung von Halbleiterkristallkörpern zu ermöglichen, die den gestellten Anforderungen, insbesondere Verträglichkeit von nonen Stromdichten und keine Beschränkung auf Halbleiter mit niedrigem spezifischen Widerstand, gerecht wird.

Diese Aufgabe wird mit den Merkmalen des Anspruchs 1 gelöst.

Weiterbildungen der Erfindung sind Gegenstand von Unteransprüchen.

Die Erfindung wird nachfolgend anhand von Ausfünrungsbeispielen näher erläutert, die in den Zeichnungen dargestellt sind.
- FIG 1: zeigt schematisch einen stark vereinfachten Querschnitt durch eine Elektrolyt-Doppelzelle;
- FIG 2 und 3: zeigen die Kennlinien des Systems am Beispiel von p-Silicium; 2: ohne Beleuchtung, 3: mit Beleuchtung;
- FIG 4 und 5: zeigen ortsaufgelöste Messungen des Fotostroms einer p-Siliciumscheibe; 4: unter Verwendung einer herkömmlichen Stromzufuhr, 5: unter Verwendung der erfindungsgemäßen Stromzufuhr;
- FIG 6: zeigt eine Ausführungsform der Doppelzelle unter Verwendung nur einer Gleichspannungsquelle.

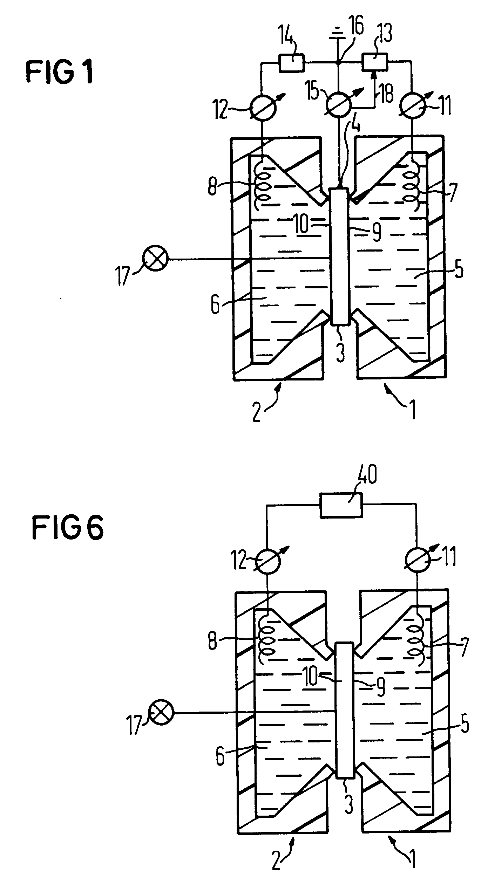

In einer Ausführungsform des Verfahrens befindet sich gemäß FIG 1 ein Halbleiterkristallkörper (sog. Wafer) 3 zwischen zwei mit Elektrolyt 5, 6 gefüllten Halbzellen 1, 2; ein solcher Aufbau ist aus EPA 0295440 bekannt. Als Elektrolyt kann z.B. 2%ige Flußsäure mit Zusatz eines Netzmittels verwendet werden. In der 1. Halbzelle 1 befindet sich der Elektrolyt 5 in Kontakt mit einer Elektrode 7 und der Vorderseite 9 des Wafers 3, die im folgenden stets die Arbeitsseite darstellt. Der Wafer 3 ist über einen ohmschen Kontakt 4 und ein Amperemeter 15 an eine Gleichspannungsquelle 13 angeschlossen, deren anderer Pol über ein Amperemeter 11 mit der Elektrode 7 verbunden ist.

Die 2. Halbzelle 2 an der Waferrückseite 10 ist analog aufgebaut: Eine 2. Elektrode 8 im Elektrolyt 6 ist über ein Amperemeter 12 mit einer Gleichspannungsquelle 14 verbunden, deren anderer Pol ebenfalls über das Amperemeter 15 und den ohmschen Kontakt 4 an den Wafer 3 angeschlossen ist. Der gemeinsame Pol 16 kann auf ein definiertes Potential, z.B. Erdpotential, gelegt werden. In jeder Halbzelle kann der Elektrolyt umgewälzt und entlüftet werden (nicht dargestellt). Der auf der Vorderseite 9 durchzuführende Bearbeitungs-oder Meßschritt erfordert immer einen Stromfluß durch den Elektrolyt 5 in der 1. Halbzelle 1 zwischen der Halbleiterscheibe 3 und der 1. Elektrode 7.

Erfindungsgemäß erfolgt die Stromzufuhr über den Halbleiter-Elektrolyt-Kontakt an der Scheibenvorderseite 9. Die beiden Halbzellen 1, 2 können als voneinander unabhängig angesehen werden, ihre Strom-Spannungs-Kennlinien sind nur durch die chemischen Reaktionen an den jeweiligen Grenzflächen Elektrolyt-Halbleiter und Elektrolyt-Elektrode gegeben. Für freigewählte Spannungen U₁ an Spannungsquelle 13 und U₂ an Spannungsquelle 14 fließen die Ströme I₁ und I₂ entsprechend der jeweiligen Kennlinie in den beiden Halbzellen 1, 2. Durch das Amperemeter 15 fließt entsprechend den Kirchhoff'schen Gesetzen der Differenzstrom I₃ = I₁ - I₂. Für praktische Anwendungen soll in der Regel I₃ = 0 sein.

Dies bedingt eine Reihenschaltung der Spannungsquellen 13 und 14 derart, daß entgegengesetzte Pole am gemeinsamen Pol 16 anliegen. Die beiden Spannungen müssen so gewählt werden, daß I₁≈ -I₂ ist. Da die zweite Halbzelle 2 immer so gepolt ist, daß der Halbleiter-Elektrolyt-Kontakt sperrt, läßt sich diese Bedingung in der Praxis nur erfüllen, falls die sperrende Halbleiteroberfläche beleuchtet wird, so daß aufgrund der Erzeugung von Minoritätsträgern ein Fotostrom fließt.

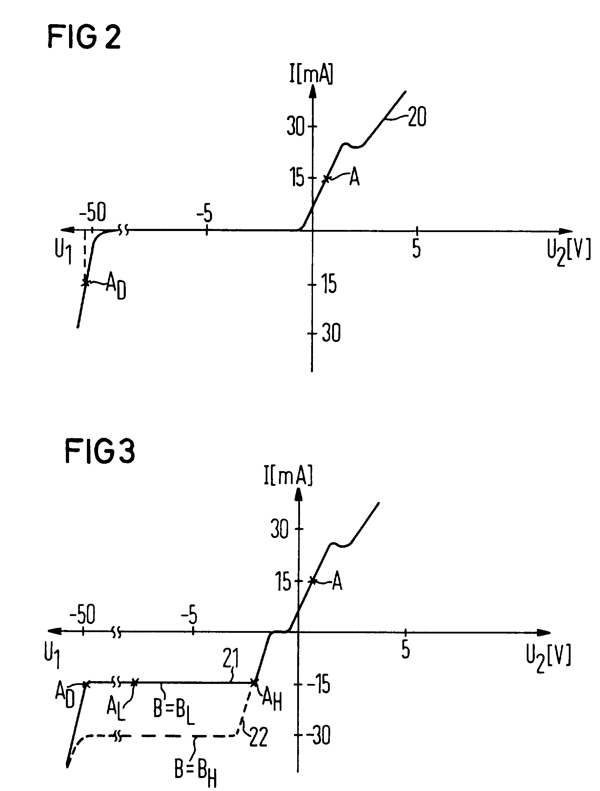

In FIG 2 und 3 sind die Kennlinien 20, 21, 22 ohne und mit Beleuchtung am Beispiel von p-Silicium als Halbleiter mit einem spezifischen Widerstand von ca.1Ωcm in einem ca. 2,5 %igen HF-Elektrolyten dargestellt (siehe V. Lehmann et al in "Proceed-ings of tne Flat-Plate Solar Array Project Research Forum on the High Speed Growtn And Cnaracterization of Crystals for Solar Cells", JPL-Publication 84/23, 1983, S. 527 ff).

Mit Hilfe der Parameter des Systems wie Spannung, Elektrolytart, -konzentration und Beleuchtungsstärke kann die je nach Anwendung erforderliche Stromstärke (d.h. der Arbeitspunkt) eingestellt werden und mit Hilfe eines Regelkreises 18 bei den im allgemeinen zeitlich nicht konstanten elektrochemischen Prozessen nachgeregelt werden.

Das Verfahren wird am Beispiel von p-Silicium als Halbleiter anhand der Kennlinien 20, 21, 22 in FIG 2 und 3 näher erläutert.

Die zu bearbeitende Vorderseite 9 des Wafers 3 sei anodisch geschaltet (d.h. Pluspol von Gleichspannungsquelle 13 an der Halbleiterscheibe 3). Der gewünschte Strom I₁ in Halbzelle 1 sei 15mA (Arbeitspunkt A). Die benötigte Spannung U₁ ergibt sich aus dem rechten Teil der Kennlinie 20 in FIG 2 zu U₁ etwa 0,8 V. Die Zufuhr der benötigten 15 mA durch den Elektrolyten 6 in der 2. Halbzelle 2 erfolgt durch den Fotostrom, der durch die Beleuchtung der Scheibenrückseite 10 mit der Lichtquelle 17 erzeugt wird.

An der FIG 3 ist zu erkennen, daß die Beleuchtung der Scheibenrückseite 10 zwei Möglichkeiten zur Wahl des Arbeitspunktes in der 2. Halbzelle 2 bietet:
a) Die Beleuchtungsstärke B wird so gewählt, daß gerade der gewünschte Strom fließt (B=B_{L}, Arbeitspunkt A_{L} auf Kennlinie 21 in FIG 3). Für 15 mA muß die Beleuchtungsstärke ca. 460W/cm bei einer dem Sonnenlicht entsprechenden Spektralverteilung betragen.
b) Die Beleuchtungsstärke wird so gewählt, daß der Fotostrom etwas größer ist als der gewünschte Strom (B=B_{H}, Kennlinie 22). Der Arbeitspunkt A_{H} wird in den ansteigenden Ast der Kennlinie bei kleinen Spannungen gelegt.

Je nach Anwendungszweck kann die Scheibe ganzflächig beleuchtet werden oder mit einem punktförmigen Lichtfleck abgerastert werden (durch Fokussierung des Lichtstrahls und/oder Verwendung eines Lasers). Bei einem zeitlichen nicht konstanten Strom wird eine Regelung 18 z.B. mit Hilfe der Bedingung I₃ = 0 erreicht, indem U₂ so geändert wird, daß I₃ verschwindet.

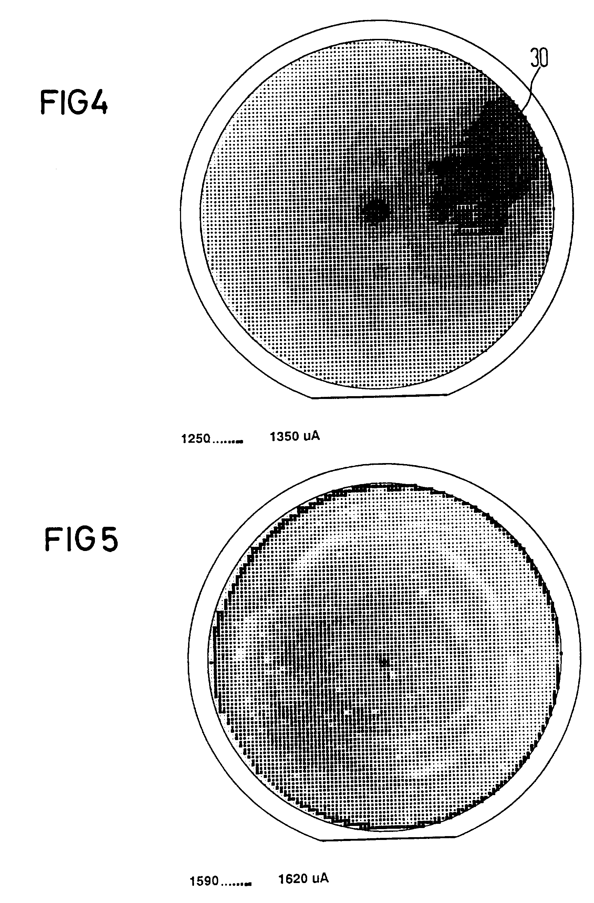

Weitere Ausführungsformen und Anwendungen:
1) Aus J.Electrochem. Soc. : Solid-State Science and Technology, Band 135, Nr. 11(1988), Seiten 2831-2835 ist die ortsaufgelöste Messung von Fotoströmen zur Bestimmung der Minoritätsträger-Diffusionslänge im Halbleiter bekannt : p-dotiertes Silicium.
   Es wird die Rückseite 10 anodisch und die Vorderseite 9 kathodisch beschaltet. In diesem Fall wird i.a. die Vorderseite 9 mit einer Lichtquelle (nicht dargestellt) beleuchtet, da die 1. Halbzelle 1 bei Dunkelheit sperrt. Insbesondere bei dieser Schaltungsart wird die Möglichkeit der punktförmigen Beleuchtung eingesetzt, um ortsaufgelöst arbeiten zu können.
   Anhand einer solchen Messung ist in FIG 4 und 5 ein Vergleich des erfindungsgemäßen Verfahrens mit einem herkömmlichen gezeigt. Die in Sperrichtung gepolte Vorderseite 9 einer p-Siliziumscheibe 3 war einem 1%igen Flußsäureelektrolyt 5 ausgesetzt und wurde mit einem HeNe-Laserstrahl abgerastert. Der dabei fließende Fotostrom wurde gemessen und grafisch in einer Grautonskala dargestellt.
   Für die der FIG 4 zugrundeliegende Messung wurde das herkömmliche Verfahren mit einer Stromzufuhr über eine Kontaktnadel am Rande der Scheibe verwendet. Für die der FIG 5 zugrundeliegenden Messung wurde die Stromzufuhr über einen Elektrolytkontakt an der Scheibenrückseite 10 eingesetzt. Während in FIG 4 der Einfluß der Kontaktspitze (30) die echten Fotostromschwankungen völlig überdeckt, erlaubt das erfindungsgemäße Verfahren eine wesentlich gesteigerte Empfindlichkeit der Messung ohne störende Effekte durch die Kontaktierung.
   n-dotiertes Silicium.
   Die Ausführungen für p-Silicium lassen sich im wesentlichen auf n-Silicium übertragen. Jedoch fließt bei n-Silicium zusätzlich zum durch Licht generierten Fotostrom (getragen durch Löcher als Minoritätsträger) ein Elektronenstrom, der durch Injektion von Elektronen in der Grenzfläche Silicium-Elektrolyt erzeugt wird. Die Abhängigkeit dieses zusätzlichen Elektroneninjektionsstroms von den Parametern des Systems ist grundsätzlich bekannt (siehe V. Lehmann, Dissertation, Universität Erlangen, 1988).
   Wie bei p-Silicium kann entweder die Rückseite 10 anodisch und die Vorderseite 9 kathodisch beschaltet werden, wobei die Rückseite i.a. beleuchtet werden muß, oder umgekehrt.
2) Siliciumscheiben mit pn-Übergängen oder Dotierstufen.
   Das Verfahren ist auch hier anwendbar. Bei Vorliegen einer Dotierstufe tritt nur eine geringfügige Änderung der Kennlinien auf, bei Scheiben mit pn-Übergängen stellt die Anordnung (z.B. p-Siliciumsubstrat/n-Siliciumschicht/Silicium-Elektrolyt-Übergang) jedoch eine Art Transistor dar. Infolgedessen kann bei entsprechenden Spannungsverhältnissen auch ohne Beleuchtung ein über den pn-Übergang injizierter Strom fließen, der von Dotierung, Geometrie, Beleuchtung und dem verwendeten Arbeitspunkt abhängt. Die beabsichtigte Stromzuführung im Sinne der Erfindung ist aber immer erreichbar. Liegt eine Dotierstufe oder ein pn-Übergang nicht auf der gesamten Fläche vor, ist dies als Mischfall entsprechend zu behandeln.
3) Andere Halbleiter
   Die für Siliciumscheiben durchgeführten Überlegungen lassen sich direkt auf andere Halbleiter übertragen. Bekannt sein müssen lediglich die Kennlinien in geeigneten Elektrolyten.
4) Andere Spannungsversorgung
   Wie in FIG 6 angegeben, kann auch nur ein Netzgerät 40 verwendet werden, das mit den beiden Elektroden 7 und 8 verbunden wird, da aufgrund der erfindungsgemäßen Stromzufuhr über den Silicium-Elektrolyt-Kontakt der ohmsche Kontakt 4 nicht zur Stromzufuhr benötigt wird. Die Spannungsquelle 40 erzeugt die Spannung U₁ + U₂.
   Im allgemein vorliegenden Fall eines zeitlich nicht konstanten Stroms unterscheidet sich diese Schaltungsart von derjenigen mit zwei Spannungsquellen:
   Ändert sich I₁, muß sich auch I₂ entsprechend ändern, und bei konstant gehaltener Spannung U₁ + U₂ verschieben sich die Arbeitspunkte, was wiederum eine Änderung der internen Teilspannung U₁ und damit der Tiefe der Raumladungszone im Halbleiter 3 zur Folge hat. Ferner steht keine einfache Regelmöglichkeit zur Verfügung. Die Arbeitspunktverschiebung ist jedoch durch geeignete Wahl der Kennlinie optimierbar.
5) Einseitige Kontaktierung durch den Elektrolyten.
   Das erfindungsgemäße Verfahren eines Elektrolytkontaktes auf der Scheibenrückseite 10 ist auch dann anwendbar, wenn auf der Scheibenvorderseite 9 der Stromfluß nicht durch einen Elektrolyten 5 erfolgt, sondern in anderer Weise, z.B. über ein elektrisch leitendes gasförmiges Medium (Plasma) oder einen Metallkontakt.
   Der benötigte Strom für die vorgesehene Bearbeitung der Vorderseite bestimmt die vorteilhafteste Ausführung der Stromzufuhr durch den Elektrolytkontakt auf der Rückseite.

## Patentansprüche

1. Verfahren zum großflächigen elektrischen Kontaktieren eines Halbleiterkristallkörpers mit Hilfe von Elektrolyten, bei welchem
- an der zu bearbeitenden Vorderseite (9) des Halbleiterkristallkörpers (3) eine erste Halbzelle (1) mit einer ersten Elektrode (7) angebracht wird,
- an der Rückseite (10) des Halbleiterkristallkörpers (3) eine zweite Halbzelle (2) mit einer zweiten Elektrode (8) angebracht wird,
- mindestens die zweite Halbzelle (2) mit einem Elektrolyt (6) gefüllt wird, welcher mit der zweiten Elektrode (8) und der Rückseite (10) des Halbleiterkristallkörpers (3) in Kontakt steht,
- zwischen den beiden Elektroden (7, 8) mit Hilfe von mindestens einer Spannungsquelle (40; 13, 14) eine Spannung angelegt wird,
**dadurch gekennzeichnet**, daß durch die angelegte Spannung die erste Halbzelle (1) in Durchlaßrichtung und die zweite Halbzelle (2) in Sperrichtung gepolt wird, und daß ein Stromfluß von der ersten Elektrode (7) durch den Halbleiterkristallkörper (3) zur zweiten Elektrode (8) mit Hilfe Beleuchtung der Rückseite (10) des Halbleiterkristallkörpers (3) eingestellt wird.

2. Verfahren nach Anspruch 1, **dadurch gekennzeichnet**, daß ein elektrischer Regelkreis (18) zur Aufrechternaltung eines optimalen Arbeitspunktes vorgesehen ist.

3. Verfahren nach Anspruch 1 oder 2, **dadurch gekennzeichnet**, daß die Beleuchtung der Oberfläche (10) des Halbleiterkristallkörpers (3) ganzflächig erfolgt.

4. Verfahren nach Anspruch 1 oder 2, **dadurch gekennzeichnet**, daß der Halbleiterkristallkörper (3) mit einem punktförmigen Lichtfleck abgerastert wird.

5. Verfahren nach einem der Ansprüche 1 bis 4, **dadurch gekennzeichnet**, daß eine Gleichspannungsquelle (40) verwendet wird, deren Pole mit je einer Elektrode (7, 8) verbunden werden.

6. Verfahren nach einem der Ansprüche 1 bis 4, **dadurch gekennzeichnet**, daß zwei in Reihe geschaltete Gleichspannungsquellen (13, 14) verwendet werden, die jeweils an eine Elektrode (7, 8) und gemeinsam über einen ohmschen Kontakt (4) an den Halbleiterkristallkörper (3) angeschlossen sind, wobei entgegengesetzte Pole der Spannungsquellen am gemeinsamen Pol (16) anliegen und der gemeinsame Pol auf ein definiertes Potential gelegt wird.

7. Verwendung des Verfahrens nach einem der Ansprüche 1 bis 6, bei Halbleiterkristallkörpern (3) mit Dotierstufen oder pn-Übergängen.

## Claims

1. Method for large-area electrical connection of a semiconductor crystal body with the aid of electrolytes, in which
- a first half-cell (1) having a first electrode (7) is fixed to the front side (9), which is to be processed, of the semiconductor crystal body (3),
- a second half-cell (2) having a second electrode (8) is fixed to the rear side (10) of the semiconductor crystal body (3),
- at least the second half-cell (2) is filled with an electrolyte (6) which is in contact with the second electrode (8) and the rear side (10) of the semiconductor crystal body (3),
- a voltage is applied between the two electrodes (7, 8) with the aid of at least one voltage source (40; 13, 14),
characterized in that, by the applied voltage, the first half-cell (1) is polarized in the conducting direction and the second half-cell (2) is polarized in the nonconducting direction, and in that a current flow is set up from the first electrode (7), through the semiconductor crystal body (3), to the second electrode (8) with the aid of illumination of the rear side (10) of the semiconductor crystal body (3).

2. Method according to Claim 1, characterized in that an electrical control circuit (18) for maintaining an optimum working point is provided.

3. Method according to Claim 1 or 2, characterized in that the illumination of the surface (10) of the semiconductor crystal body (3) takes place over its entire area.

4. Method according to Claim 1 or 2, characterized in that the semiconductor crystal body (3) is scanned with a point-like light source.

5. Method according to one of Claims 1 to 4, characterized in that use is made of a DC voltage source (40) whose poles are each connected to one electrode (7, 8).

6. Method according to one of Claims 1 to 4, characterized in that use is made of two DC voltage sources (13, 14) connected in series, which are respectively connected to an electrode (7, 8) and, in common, via an ohmic contact (4) to the semiconductor crystal body (3), opposite poles of the voltage sources being connected to the common pole (16), and the common pole being maintained at a defined potential.

7. Use of the method according to one of Claims 1 to 6 in the case of semiconductor crystal bodies (3) having stepped doping profiles or pn junctions.

## Revendications

1. Procédé d'établissement d'un contact électrique sur une grande surface sur un corps à cristaux de semiconducteur à l'aide d'électrolytes, dans lequel
- on applique une première demi-cellule (1) comportant une première électrode (7) à la face avant (9) à traiter du corps (3) à cristaux de semiconducteur,
- on applique une seconde demi-cellule (2) comportant une seconde électrode (8) à la face (10) arrière du corps (3) à cristaux de semiconducteur,
- on remplit au moins la seconde demi-cellule (2), d'un électrolyte (6), qui est en contact avec la seconde électrode (8) et avec la face arrière (10) du corps (3) à cristaux de semiconducteur,
- on applique une tension entre les deux électrodes (7, 8) à l'aide d'au moins une source (40 ; 13, 14) de tension,
caractérisé en ce que l'on polarise, par la tension appliquée, la première demi-cellule (1) dans le sens passant et la seconde demi-cellule (2) dans le sens de blocage et on établit le passage d'un courant de la première électrode (7) à la seconde électrode (8) avec passage par le corps (3) à cristaux de semiconducteur en éclairant la face arrière (10) du corps (3) à cristaux de semiconducteur.

2. Procédé suivant la revendication 1, caractérisé en ce qu'un circuit électrique (18) de régulation est prévu pour le maintien d'un point de fonctionnement optimal.

3. Procédé suivant la revendication 1 ou 2, caractérisé en ce que l'éclairement de la surface (10) du corps (3) à cristaux de semiconducteur s'effectue sur toute la surface.

4. Procédé suivant la revendication 1 ou 2, caractérisé en ce que l'on balaye le corps (3) à cristaux de semiconducteur par une tache ponctuelle de lumière.

5. Procédé suivant l'une des revendications 1 à 4, caractérisé en ce que l'on utilise une source (40) de tension continue, dont on relie les pôles chacun à une électrode (7, 8).

6. Procédé suivant l'une des revendications 1 à 4, caractérisé en ce que l'on utilise deux sources (13, 14) de tension continue, qui sont branchées en série et qui sont connectées à une électrode (7, 8) et en commun par l'intermédiaire d'un contact ohmique (4) au corps (3) à cristaux de semiconducteur, les pôles de signes opposés des sources de tension étant appliqués au pôle (16) commun et le pôle commun étant porté à un potentiel défini.

7. Utilisation du procédé suivant l'une des revendications 1 à 6, dans des corps (3) à cristaux de semiconducteur ayant des niveaux de dopage ou des jonctions pn.
